# EUROPEAN PATENT APPLICATION

(11) **EP 3 034 649 A1**
(43) Date of publication of application: **22.06.2016**
(21) Application number: 15200233.3
(22) Date of filing: 15.12.2015
(51) Int. Cl.: C23C 18/18, C23C 18/30, B01J 23/44, B01J 35/00, H05K 3/18, C23C 18/16, C09D 11/52

(54) **PLATING CATALYST COATING AGENT AND LAMINATE OBTAINED USING SAME**

(30) Priority: 19.12.2014 JP 2014256899; 29.07.2015 JP 2015150071
(71) Applicant: Nippon Sheet Glass Company, Limited, Tokyo 108-6321 (JP)
(72) Inventor: TSUDA, Masanobu, Tokyo, 108-6321 (JP); OGINO, Masashi, Tokyo, 108-6321 (JP); UCHIYAMA, Kenji, Tokyo, 108-6321 (JP)
(74) Representative: Hart-Davis, Jason

(57) **Abstract**

Provided is a plating catalyst coating agent that offers good plating quality, is excellent in adhesion, and enables thinning of a plating catalyst layer. The plating catalyst coating agent includes a carrier (A) supporting catalytic metal fine particles and a binder (B), the binder (B) includes an aqueous resin emulsion (B1), the carrier (A) has an average particle diameter (D50) of 20 to 90 nm, the catalytic metal fine particles supported on the carrier (A) include palladium, and a content ratio of the binder (B) to the carrier (A) ((B)/(A)) is 0.25 to 0.60.

## Description

The present invention relates to a plating catalyst coating agent and a laminate obtained using the same.

In recent years, electronic devices have been getting smaller and faster with the advancement of electronic parts industry. Also for printed circuit boards etc. on which LSIs are mounted, it is required that high density and high reliability should be achieved by fine patterns.

As a method of forming a conductor circuit in production of a printed circuit board, there is conventionally known an etched foil method in which a copper foil is laminated onto a substrate and is then photo-etched to form a conductor circuit. With this method, a conductor circuit excellent in adhesion to a substrate can be formed. This method, however, has a major disadvantage in that, owing to the large thickness of the copper foil, it is difficult to obtain high-precision fine patterns by etching.

Hence, in order to meet the demand for the achievement of high precision and ultrahigh density of printed circuit boards, photolithography has become, due to its high performance in microfabrication, commonly used as a technique for forming circuits of printed circuit boards.

Furthermore, in view of the fact that the reliability of a printed circuit board is greatly influenced by the suitability of an adhesive layer for electroless plating, there have been proposed, for example, a printed circuit board having a highly peel-resistant, ultrahigh-density conductor pattern and a method of producing the printed circuit board using electroless plating and photolithography in combination (JP 5-239659 A).

Examples of the method of forming a circuit of a printed circuit board using photolithography include a method using photolithography in combination with copper plating. Such a method includes steps such as pretreatment for electroless plating, electroless plating, electrolytic copper plating, photoresist (photosensitive material) application, prebake, exposure, developing and rinsing, postbake, etching, resist removal, and rinsing.

In order to further improve the performance of a printed circuit board having a circuit produced by photolithography, there has been proposed, for example, a method in which, for the purpose of improving the adhesion between a base material and copper, the surface of the base material is roughened before electroless plating. Examples of the method of such pretreatment include: a method in which the surface of a base material is etched with an etching solution such as chromic acid or an alkaline aqueous solution so as to form recesses and projections in the treated surface (JP 7-207451 A); and a method in which a sulfuric acid-hydrogen peroxide mixture is brought into contact with a base material so as to remove organic contaminants from the treated surface of the base material, or the treated surface of the base material is oxidized to increase its wettability (WO 2008/056603 A1).

As stated above, however, the circuit formation method using photolithography combined with copper plating inevitably includes many steps, requires a photomask for each wiring pattern, and is therefore cumbersome and complicated. Furthermore, an expensive photoresist material and exposure device are needed.

Therefore, the development of a material that enables simpler circuit formation has been desired.

The present invention aims to provide a plating catalyst coating agent that offers good plating quality, is excellent in adhesion, and enables thinning of a plating catalyst layer. The present invention also aims to provide a plating catalyst coating agent whose use in circuit pattern formation can reduce the number of production steps and that is therefore industrially advantageous.

The present invention provides a plating catalyst coating agent including a carrier (A) supporting catalytic metal fine particles and a binder (B). The binder (B) includes an aqueous resin emulsion (B1), the carrier (A) has an average particle diameter (D50) of 20 to 90 nm, the catalytic metal fine particles supported on the carrier (A) include palladium (Pd), and a content ratio of the binder (B) to the carrier (A) ((B)/(A)) is 0.25 to 0.60.

The present invention also provides a plating catalyst laminate including a base material and a plating catalyst layer having a thickness of 2.0 µm. The plating catalyst layer is formed using the plating catalyst coating agent.

The use of the plating catalyst coating agent of the present invention provides good plating quality and excellent adhesion, and also enables thinning of a plating catalyst layer. The fact that the plating catalyst layer can be thinly formed makes it possible for the total thickness of the plating catalyst layer and the plating laminated thereon (the thickness of the plating catalyst layer + the thickness of the plating layer) to be 5.0 µm or less and for the wire width to be narrow (5.0 µm or less, for example). Furthermore, a method of forming a circuit pattern using the plating catalyst coating agent of the present invention, in contrast to methods using photolithography, does not need the use of a template, and therefore dose not require a template production step. Not only does this method consist of fewer steps, but also it does not require an expensive photoresist material or exposure device. Thus, the method is simple and hence industrially advantageous.

The plating catalyst coating agent of the present invention is characterized in that it includes a carrier (A) supporting catalytic metal fine particles and a binder (B), the binder (B) includes an aqueous resin emulsion (B1), the carrier (A) has an average particle diameter (D50) of 20 to 90 nm, the catalytic metal fine particles supported on the carrier (A) include palladium, and the content ratio of the binder (B) to the carrier (A) ((B)/(A)) is 0.25 to 0.60.

The carrier (A) used in the present invention to support the catalytic metal fine particles (which may be simply referred to as "carrier (A)" or "catalyst-supporting carrier (A)" hereinafter) will now be described.

The average particle diameter (D50) of the carrier (A) is 20 to 90 nm, preferably about 21 to 85 nm, more preferably about 23 to 80 nm, even more preferably about 25 to 75 nm, in order that the carrier (A) can have good dispersibility in the binder (B), that the thickness of the plating catalyst layer can be reduced, and that the peel strength can be enhanced by adjusting the content of the carrier (A) relative to the binder (B) within a specified range. The average particle diameter (D50) of the carrier is preferably greater than the average particle diameter (D50) of the catalytic metal fine particles supported on the carrier.

The carrier used in the present invention is not particularly limited as long as the effect of the present invention is not impaired. For example, the carrier may be in the form of any of various particles, such as spherical, approximately spherical, fibrous, columnar, blocky, and cluster-like particles. The material of the carrier is not particularly limited as long as the effect of the present invention is not impaired. For example, in terms of ensuring the affinity for the binder (B) (particularly, the aqueous resin emulsion (B1)) and making a greater contribution to improvement in adhesion, at least one selected from the group consisting of a carbon material, a metal oxide, and silica can be used. The carbon material is more preferable in terms of, for example, the affinity for the binder (B) (particularly, the aqueous resin emulsion (B1)). The above-mentioned materials may be used alone or two or more thereof may be used in combination. These materials may be
commercially-available ones.

The carbon material is not particularly limited, and examples thereof include carbon black, carbon nanotube, fullerene, and graphite. The metal oxide is not particularly limited, and examples thereof include titanium oxide, zinc oxide, aluminum oxide, and magnesium oxide. Among the above-mentioned carrier materials, carbon black is particularly preferable in terms of the ease of support of the catalytic metal, the affinity for the binder (B) (particularly, the aqueous resin emulsion (Bl)), and the economic efficiency.

The catalytic metal fine particles supported on the carrier (A) include at least palladium (Pd). The catalytic metal is not particularly limited as long as the effect of the present invention is not impaired. Instead of or in addition to palladium, a metal (the term "metal" as used in the present invention includes "alloy") having catalytic ability required to induce electroless metal plating reaction may be used. Examples of such a catalytic metal other than palladium include Pt, Ni, Ag, Au, and alloys thereof. The catalytic metal fine particles supported on the carrier (A) are particularly preferably palladium fine particles. The catalytic metal fine particles used in the present invention may or may not be coated with a stabilizing agent (e.g., sucrose-derived compounds including sucrose).

Specifically, the catalyst-supporting carrier (A) may have a structure having both exposed portions in which the carrier surface is exposed and supporting portions on which the catalytic metal is supported. In this case, the amount of the catalytic metal used can be reduced, as compared with the case where the carrier surface is almost fully covered with the catalytic metal. This can contribute to resource saving and is also advantageous for cost reduction of the plating laminate.

In the catalyst-supporting carrier (A), the catalytic metal including palladium is supported in the form of fine particles on the carrier surface. The average particle diameter (D50) of the catalytic metal fine particles (preferably palladium fine particles) supported on the carrier surface is preferably 5 nm or more and 40 nm or less, and may be any value selected from 5, 6, 9, 10, 11, 15, 16, 20, 21, 25, 26, 28, 29, 30, 31, 34, 35, 37, 39, and 40 nm or may be within the range defined by two values arbitrarily selected from the above values (the values at the limits of the range may be included or excluded). In order to obtain good plating quality, the average particle diameter of the catalytic metal fine particles is more preferably 7 nm or more and 38 nm or less, and even more preferably 8 nm or more and 36 nm or less.

The volume-based average particle diameters (D50) of the carrier (A) and the catalytic metal fine particles supported on the surface of the carrier (A) in the present invention can be measured with a particle size distribution analyzer that uses dynamic light scattering (DLS) (e.g., Nanotrac Wave series manufactured by NIKKISO CO., LTD. (Product code: Nanotrac Wave-EX250, etc.)), and refer to diameters corresponding to a cumulative volume of 50%.

The ratio of the supported catalytic metal fine particles in the carrier (A) (the ratio of supported catalyst) is not particularly limited, and is preferably 0.01 to 30 wt%, more preferably 0.1 to 20 wt%, even more preferably 0.3 to 10 wt%, and still even more preferably 0.5 to 5 wt%. The ratio of the supported catalytic metal fine particles is determined as follows: the catalytic metal (preferably Pd) fine particle-supporting carrier (A) (whose weight is used as a reference weight) is put in aqua regia to dissolve the catalytic metal at 150°C, the concentration of the catalytic metal in the solution having been 100-fold diluted with ultrapure water is measured by ICP-MS, and the amount of the catalytic metal per reference weight (the ratio of supported catalyst) is calculated.

In the plating catalyst coating agent of the present invention, the carrier (A) supporting the catalytic metal is preferably dispersed throughout the binder (B). The binder (B) mainly serves to hold the carrier (A) dispersed and form the plating catalyst layer.

The binder (B) used in the present invention will now be described.

The content ratio of the binder (B) to the carrier (A) ((B)/(A)) is 0.25 to 0.60. In terms of enhancing the adhesion between the plating catalyst layer and the plating base material (which may be referred to as a "base material" hereinafter) and the adhesion between the plating catalyst layer and the copper plating layer so as to obtain a high peel strength, the content ratio is preferably 0.30 to 0.60 and more preferably 0.33 to 0.58. The content ratio refers to the weight ratio of solids.

The binder (B) of the present invention includes at least the aqueous resin emulsion (B1). The combined use of the aqueous resin emulsion (B1) with the above-described carrier (A) can provide good plating quality, improve the adhesion between the plating catalyst layer and the base material and the adhesion between the plating catalyst layer and the copper plating layer, and reduce the thickness of the plating catalyst layer. When the aqueous resin emulsion (B1) and a curing agent (B2) are used in combination, the binder (B) further includes the curing agent (B2). The binder (B) of the present invention may include a binder component other than the aqueous resin emulsion (B1) as long as the effect of the present invention is not impaired. Such a binder component is not particularly limited, and a commonly-known one can be used. Preferably, the binder (B) is the aqueous resin emulsion (B1) or consists of the combination of the aqueous resin emulsion (B1) and the curing agent (B2).

The aqueous resin emulsion (B1) used in the present invention is not particularly limited. Examples thereof include a (meth)acrylic resin emulsion; a urethane resin emulsion; a polyester resin emulsion; an epoxy resin emulsion; a fluorine resin emulsion; an alkyd resin emulsion; a melamine resin emulsion; a phenoxy resin emulsion; a phenolic resin emulsion; an acrylic-styrene copolymer emulsion; a (meth)acrylic acid ester copolymer emulsion; vinyl acetate (co)polymer emulsions such as a vinyl acetate polymer emulsion, an ethylene-vinyl acetate copolymer emulsion, and a vinyl acetate-saturated branched fatty acid vinyl ester copolymer emulsion; synthetic rubber latices based on butadiene, isoprene, chloroprene, styrene/butadiene copolymer, and styrene/butadiene/acrylic copolymer; a resin emulsion of vinyl chloride, vinylidene chloride, or a copolymer thereof; a hybrid resin emulsion; and a modified (e.g., bisphenolA-modified) resin emulsion. These may be used alone, or two or more thereof may be used in combination. These may be commercially-available ones. Among the above examples of the aqueous resin emulsion (B1), at least one selected from the group consisting of an epoxy resin emulsion, a polyester resin emulsion, a modified epoxy resin emulsion, and a modified polyester resin emulsion is particularly preferable. In the present description, the expression "(meth)acryl" collectively refers to "acryl" and "methacryl". The expression "vinyl acetate (co)polymer" collectively refers to "homopolymer of vinyl acetate" and "copolymer of vinyl acetate with another monomer".

The curing agent (B2) for the aqueous resin emulsion (B1) is not particularly limited, and examples thereof include an aliphatic polyamine, an aromatic polyamine, an acid anhydride, an amidopolyamine, dicyandiamide, and a polyamide. Preferred are an aliphatic polyamine and an aromatic polyamine. These may be used alone, or two or more thereof may be used in combination. These may be commercially-available ones.

The aliphatic polyamine is not particularly limited as long as it is an aliphatic polyamine compound having two or more amino groups. Examples thereof include ethylenediamine, diethylenetriamine, triethylenetetramine, meta-xylylenediamine, 1,3-bis(aminomethyl)cyclohexane, p-menthane-1,8-diamine, isophoronediamine, and bis(4-amino-3-methylcyclohexyl)methane.

The aromatic polyamine is not particularly limited as long as it is an aromatic polyamine compound having one or more aromatic groups and two or more amino groups. Examples thereof include meta-phenylenediamine, 4,4'-diaminodiphenylmethane, and 4,4'-diaminodiphenyl sulfone.

Examples of the acid anhydride include carboxylic anhydrides such as hexahydrophthalic anhydride, methyltetrahydrophthalic anhydride, and pyromellitic dianhydride.

As the curing agent (B2), there may be used a modified compound as long as it functions as a curing agent for the aqueous resin emulsion (B1). The modified compound is preferably a modified aliphatic polyamine. The curing agent (B2) is suitably used especially when the aqueous resin emulsion (B1) is an epoxy resin emulsion or a modified epoxy resin emulsion (preferably, a bisphenol A-modified epoxy resin emulsion).

The plating catalyst coating agent of the present invention may further include a curing accelerator where necessary. The curing accelerator is not particularly limited, and examples thereof include urea derivatives such as 3-(3,4-dichlorophenyl)-1,1-dimethylurea and tertiary amines. The curing accelerator can be selected as appropriate depending on the type of the curing agent. Examples of the combination of the curing agent and the curing accelerator include: a combination of dicyandiamide and a urea derivative serving as the curing accelerator; and a combination of a carboxylic anhydride and a tertiary amine serving as the curing accelerator.

The plating catalyst coating agent of the present invention include a solvent (C). The solvent (C) is not particularly limited, and is suitably water and/or a water-soluble organic solvent. Examples of the water-soluble organic solvent include alcohols, ethers, ketones, esters, amides, amines, aromatic hydrocarbons, sulfur-containing compounds, nitrogen-containing heterocyclic compounds, propylene carbonate, and ethylene carbonate. One water-soluble organic solvent may be used alone, or two or more water-soluble organic solvents may be used in combination.

Examples of the alcohols include methanol, ethanol, butanol, pentanol, n-hexanol, glycerin, ethylene glycol, diethylene glycol, triethylene glycol, tetraethylene glycol, polyethylene glycol, propylene glycol, dipropylene glycol, tripropylene glycol, polypropylene glycol, hexylene glycol, trimethylolethane, and trimethylolpropane.

Examples of the ethers include: alkyl ethers such as butyl ethyl ether, butyl propyl ether, and dibutyl ether; polyhydric alcohol alkyl ethers such as ethylene glycol monomethyl ether, ethylene glycol monoethyl ether, ethylene glycol mono-n-butyl ether, ethylene glycol dimethyl ether, ethylene glycol diethyl ether, diethylene glycol monomethyl ether, diethylene glycol monoethyl ether, diethylene glycol mono-n-butyl ether, diethylene glycol dimethyl ether, diethylene glycol ethyl methyl ether, diethylene glycol diethyl ether, diethylene glycol isopropyl methyl ether, diethylene glycol butyl methyl ether, propylene glycol monomethyl ether, propylene glycol monoethyl ether, and propylene glycol dimethyl ether; polyhydric alcohol aryl ethers such as ethylene glycol monophenyl ether and ethylene glycol monobenzyl ether; propylene glycol monomethoxy ether; and propylene glycol monoethoxy ether.

Examples of the ketones include methyl ethyl ketone, methyl isobutyl ketone, isoamyl ketone, ethyl hexyl ketone, cyclopentanone, cyclohexanone, and γ-butyrolactone.

Examples of the esters include butyl acetate, pentyl acetate, hexyl acetate, propyl propionate, butyl propionate, pentyl propionate, hexyl propionate, ethylene glycol monomethyl ether acetate, propylene glycol monomethyl ether acetate, and ethyl lactate. Examples of the amides include N,N-dimethylformamide and N,N-dimethylacetamide.

Examples of the amines include monoethanolamine, diethanolamine, triethanolamine, monoethylamine, diethylamine, and triethylamine.

Examples of the aromatic hydrocarbons include toluene and xylene.

Examples of the sulfur-containing compounds include dimethyl sulfoxide, sulfolane, and thiodiethanol. Examples of the nitrogen-containing heterocyclic compounds include 2-pyrrolidone and N-methyl-2-pyrrolidone.

Among these water-soluble organic solvents, solvents having a boiling point of 200°C or less are preferable in order to prevent sintering or prevent alteration of the carrier or the binder resin. More preferred are: alcohols such as butanol, pentanol, n-hexanol, ethylene glycol, propylene glycol, and trimethylolethane; ketones such as methyl ethyl ketone, methyl isobutyl ketone, isoamyl ketone, ethyl hexyl ketone, cyclopentanone, cyclohexanone, and γ-butyrolactone; esters such as butyl acetate, pentyl acetate, hexyl acetate, propyl propionate, butyl propionate, pentyl propionate, hexyl propionate, ethylene glycol monomethyl ether acetate, propylene glycol monomethyl ether acetate, and ethyl lactate; ethers such as butyl ethyl ether, butyl propyl ether, dibutyl ether, ethylene glycol monomethyl ether, ethylene glycol monoethyl ether, ethylene glycol mono-n-butyl ether, ethylene glycol dimethyl ether, ethylene glycol diethyl ether, diethylene glycol monomethyl ether, diethylene glycol monoethyl ether, diethylene glycol dimethyl ether, diethylene glycol ethyl methyl ether, diethylene glycol diethyl ether, diethylene glycol isopropyl methyl ether, propylene glycol monomethyl ether, propylene glycol monoethyl ether, propylene glycol dimethyl ether, propylene glycol monomethoxy ether, and propylene glycol monoethoxy ether; and aromatic hydrocarbons such as toluene and xylene.

The plating catalyst coating agent of the present invention is preferably used in electroless copper plating.

The plating catalyst coating agent of the present invention can be produced, for example, by a production method including: a step [I] of reducing a source solution containing a catalytic metal with a reductant so as to obtain a solution containing catalytic metal fine particles; a step [II] of bringing the solution containing the catalytic metal fine particles, which has been obtained in the step [I], into contact with a carrier so as to obtain a carrier (A) supporting the catalytic metal fine particles; and a step [III] of mixing the carrier (A) obtained in the step [II] with a binder (B), in which method the binder (B) includes an aqueous resin emulsion (B1), the carrier (A) has an average particle diameter (D50) of 20 to 90 nm, the catalytic metal fine particles supported on the carrier (A) include palladium, and the content ratio of the binder (B) to the carrier (A) ((B)/(A)) is 0.25 to 0.60.

### Step [I]

In the step [I] (reducing step), a source solution containing a catalytic metal is reduced with a reductant, and thus a solution containing catalytic metal fine particles is obtained. When the control of the particle diameters of the catalytic metal fine particles is adjusted, such adjustment can easily be made by adjusting the reaction conditions in this step. Additionally, performing this step before contact between the catalytic metal and the carrier also contributes to making easier the control of the particle diameters of the catalytic metal fine particles.

The solvent for the reduction reaction is not particularly limited as long as the effect of the present invention is not impaired. Examples of the solvent include: water; alcohols such as methanol, ethanol, n-propanol, isopropanol, and ethylene glycol; halogenated hydrocarbons such as methylene chloride and chloroform; cyclic ethers such as tetrahydrofuran, 2-methyltetrahydrofuran, and tetrahydropyran; nitriles such as acetonitrile and butyronitrile; aromatic hydrocarbons such as benzene and toluene; and mixtures of the above solvents. Preferred is water. Although the solvent of the catalytic metal-containing source solution and the solvent for dissolving the reductant may be different, they are preferably the same.

The catalytic metal-containing source solution is obtained by dissolving a catalytic metal-containing compound including at least palladium in the solvent for reduction reaction. The catalytic metal-containing compound is not particularly limited as long as it is soluble in the solvent for reduction reaction. Examples of the compound include: palladium compounds such as palladium chloride, palladium fluoride, palladium bromide, palladium iodide, palladium nitrate, palladium sulfate, palladium oxide, and palladium sulfide; silver compounds such as silver nitrate, silver fluoride, silver oxide, and silver acetate; gold compounds such as gold cyanide, gold trichloride, gold tribromide, gold potassium chloride, gold potassium cyanide, gold sodium chloride, and gold sodium cyanide; platinum compounds such as platinum chloride and platinum sulfate; and nickel compounds such as nickel chloride and nickel sulfate. These may be used alone, or two or more thereof may be used in combination. The content of the catalytic metal in the catalytic metal-containing source solution is not particularly limited. The content is preferably 0.001 g/L or more and more preferably 0.01 g/L or more with respect to the total amount of the catalytic metal-containing source solution. The content of the catalytic metal is preferably 5.0 g/L or less and more preferably 2.0 g/L or less with respect to the total amount of the catalytic metal-containing source solution.

The pH of the catalytic metal-containing source solution is not particularly limited as long as the effect of the present invention is not impaired. For example, the pH is preferably 1.0 to 4.5, more preferably 1.3 to 4.0, and even more preferably 1.5 to 3.5. The pH can be measured by a commonly-known method or instrument (e.g., a pH meter).

The catalytic metal-containing source solution may be heated before the reduction reaction. It is preferable to heat the catalytic metal-containing source solution before the reduction reaction after the pH of the solution is adjusted to the above range. The heating temperature differs depending on the solvent, and therefore is not particularly limited. The heating temperature is preferably in the range of a temperature 20°C lower than the boiling point of the solvent to a temperature 20°C higher than the boiling point of the solvent, and more preferably in the range of a temperature 10°C lower than the boiling point of the solvent to a temperature 10°C higher than the boiling point of the solvent. For example, when the solvent is water, the heating temperature is more preferably about 90 to 110°C, and particularly preferably a boiling temperature (100°C±5°C). The heating time is not particularly limited, and is preferably about 5 minutes to 10 hours, and more preferably about 10 minutes to 5 hours.

The reductant is not particularly limited as long as the effect of the present invention is not impaired. Examples of the reductant include: metal borohydrides such as sodium borohydride and potassium borohydride; aluminum hydrides such as lithium aluminum hydride, potassium aluminum hydride, cesium aluminum hydride, beryllium aluminum hydride, magnesium aluminum hydride, and calcium aluminum hydride; hydrazine compounds; carboxylic acid compounds such as citric acid and salts thereof, gallic acid and salts thereof, formic acid and salts thereof, acetic acid and salts thereof, fumaric acid and salts thereof, malic acid and salts thereof, succinic acid and salts thereof, and ascorbic acid and salts thereof; tannic acid and salts thereof; primary and secondary alcohols such as methanol, ethanol, isopropanol, and polyol; tertiary amines such as trimethylamine, triethylamine, diisopropylethylamine, diethylmethylamine, tetramethylethylenediamine [TMEDA], and ethylenediaminetetraacetic acid [EDTA]; hydroxylamine; ketones such as acetone and methyl ethyl ketone; ethers such as diethyl ether; aldehydes such as formaldehyde and acetaldehyde; esters such as methyl formate, methyl acetate, and ethyl acetate; and phosphines such as tri-n-propylphosphine, tri-n-butylphosphine, tricyclohexylphosphine, tribenzylphosphine, triphenylphosphine, triethoxyphosphine, 1,2-bis(diphenylphosphino)ethane [DPPE], 1,3-bis(diphenylphosphino)propane [DPPP], 1,1'-bis(diphenylphosphino)ferrocene [DPPF], and 2,2'-bis(diphenylphosphino)-1,1'-binaphthyl [BINAP]. These may be used alone, or two or more thereof may be used in combination. The salts mentioned above are not particularly limited, and examples thereof include salts of alkali metals (e.g., lithium, sodium, potassium, etc.), calcium salts, magnesium salts, and ammonium salts. Among these, citric acid and salts thereof (suitably sodium citrate (trisodium citrate), tannic acid and salts thereof, gallic acid and salts thereof, succinic acid and salts thereof, and ascorbic acid and salts thereof are preferable in terms of high reducing ability and ease of handling.

The amount of the reductant used is not particularly limited as long as the effect of the present invention is not impaired. The molar ratio between the catalyst contained in the catalytic metal fine particle-containing solution and the reductant (catalyst-to-reductant molar ratio) is preferably about 1.0:0.1 to 1.0:50, more preferably about 1.0:0.5 to 1.0:30, and even more preferably about 1.0:0.8 to 1.0:10. For example, when the catalyst is palladium chloride (PdCl₂), the palladium chloride (PdCl₂)-to-reductant molar ratio is preferably about 1.0:0.1 to 1.0:50, more preferably about 1.0:0.5 to 1.0:30, and even more preferably about 1.0:0.8 to 1.0:10.

The conditions for the reduction reaction are not particularly limited as long as the effect of the present invention is not impaired. For example, the reaction temperature is generally in the range of a room temperature (about 20°C) to a temperature around (±10°C of) the boiling point of the solvent, and is preferably a temperature around (±10°C of) the boiling point of the solvent. For example, when water is used as the solvent, the heating temperature is more preferably about 90 to 110°C, and particularly preferably a boiling temperature (100°C±5°C). The reaction time is not particularly limited, and is preferably about 1 minute to 5 hours, and more preferably about 5 minutes to 3 hours.

The reduction reaction is followed by cooling in the case where heating is performed for the reduction reaction. The temperature reached after cooling is not particularly limited, and is preferably about room temperature (5 to 35°C). After cooling, the catalytic metal fine particle-containing solution obtained is subjected to ion exchange using an ion exchange resin in order to remove impurities from the catalytic metal fine particle-containing solution. The ion exchange resin is not particularly limited as long as the effect of the present invention is not impaired, and a commercially-available ion exchange resin may be used.

In the step [I], a reaction accelerator may be further used. The reaction accelerator is not particularly limited as long as the effect of the present invention is not impaired. Examples of the reaction accelerator include: alkali metal hydroxides such as sodium hydroxide, potassium hydroxide, cesium hydroxide, and lithium hydroxide; alkali metal carbonates sodium carbonate, potassium carbonate, cesium carbonate, and lithium carbonate; alkaline-earth metal salts such as calcium hydroxide; and ammonia. These may be used alone, or two or more thereof may be used in combination.

The amount of the reaction accelerator used is not particularly limited as long as the effect of the present invention is not impaired. The molar ratio between the catalyst contained in the catalytic metal fine particle-containing solution and the reaction accelerator (catalyst-to-reaction accelerator molar ratio) is preferably about 1.0:0.01 to 1.0:10. In order to make easier the control of the particle diameters of the catalytic metal fine particles, the molar ratio is more preferably about 1.0:0.1 to 1.0:5.0, and even more preferably about 1.0:0.5 to 1.0:3.0. For example, when the catalyst is palladium chloride (PdCl₂), the palladium chloride (PdCl₂)-to-reaction accelerator molar ratio is preferably about 1.0:0.01 to 1.0:10, more preferably about 1.0:0.1 to 1.0:5.0, and even more preferably about 1.0:0.5 to 1.0:3.0. The amount of the reaction accelerator used is preferably such that, for example, the molar ratio between the reductant and the reaction accelerator (reductant-to-reaction accelerator molar ratio) is about 1.0:0.001 to 1.0:10. In order to make easier the control of the particle diameters of the catalytic metal fine particles, the molar ratio is more preferably about 1.0:0.01 to 1.0:5.0, and even more preferably about 1.0:0.05 to 1.0:3.0.

### Step [II]

In the step [II] (catalyst-supporting carrier production step), the catalytic metal fine particle-containing solution obtained in the above step [I] is brought into contact with a carrier to obtain a catalyst-supporting carrier (A) supporting the catalytic metal fine particles. The method of the contact is not particularly limited as long as the effect of the present invention is not impaired. One example is a method in which a carrier is added to and mixed with the catalytic metal fine particle-containing solution.

The carrier used in this step may be subjected to etching using a surfactant or the like. Even without such etching, however, a plating catalyst coating agent having sufficient adhesion can be obtained.

In the step [II], it is preferable to additionally perform dispersing after the catalytic metal fine particle-containing solution and the carrier are brought into contact. The method of the dispersing is not particularly limited as long as the effect of the present invention is not impaired, and a commonly-used method can be employed. Examples of the method of the dispersing include those using a muller, a kneader, a mixer (e.g., a Henschel mixer etc.) or the like.

In the step [II], the solution obtained after the contact or the solution obtained after the dispersing performed as necessary may be subjected to solvent removal and drying. The method of the solvent removal and drying is not particularly limited, and a commonly-known method can be employed. Furthermore, the solvent removal and drying may be followed by grinding. The method of the grinding is not particularly limited, and a commonly-known method can be employed.

Additionally, sintering may be performed as necessary in order to adjust the particle diameters of the catalytic metal fine particles. The conditions for the sintering can be adjusted as appropriate depending on the intended average particle diameter of the catalytic metal fine particles, and are not particularly limited as long as the effect of the present invention is not impaired. For example, the sintering temperature is preferably about 100 to 500°C, more preferably about 120 to 300°C, and even more preferably about 150 to 250°C. The sintering time can be adjusted as appropriate depending on the intended average particle diameter of the catalytic metal fine particles, and is not particularly limited as long as the effect of the present invention is not impaired. For example, the sintering time is preferably about 10 minutes to 24 hours, and more preferably about 30 minutes to 20 hours. The sintering is preferably performed under vacuum.

### Step [III]

In the step [III] (mixing step), the catalyst-supporting carrier (A) obtained in the above step [II] and the binder (B) are mixed together. Thus, the plating catalyst coating agent of the present invention can be prepared.

The solvent used for the mixing in the step [III] is not particularly limited as long as the effect of the present invention is not impaired. Examples of the solvent include: water; alcohols such as isopropanoh organic acids such as acetic acid; aromatic hydrocarbons such as benzene, toluene, xylene, ethylbenzene, and 1,2-dichlorobenzene; ethers such as tetrahydrofuran and diethyl ether; ketones such as acetone, ethyl methyl ketone, isobutyl methyl ketone, and cyclohexanone; halides such as chloroform, dichloromethane, and 1,2-dichloroethane; aliphatic hydrocarbons such as n-hexane, n-heptane, and cyclohexane; amides such as N,N-dimethylformamide and N,N-dimethylacetamide; and nitrogen-containing heterocyclic compounds such as N-methyl-2-pyrrolidone. These solvents may be used alone, or two or more thereof may be used in combination.

The conditions for the mixing are not particularly limited as long as the effect of the present invention is not impaired. Depending on the type of the binder (B), stirring and heating may be performed together as necessary. The heating temperature is not particularly limited as long as the effect of the present invention is not impaired. The upper limit of the heating temperature may be a temperature that is about 20°C lower than the boiling point of the solvent.

In the above production method of the plating catalyst coating agent of the present invention, the binder (B) and the carrier are not used in preparation of palladium fine particles; therefore, the particle diameters of the palladium fine particles can easily be controlled within the intended range.

The use of the plating catalyst coating agent of the present invention eliminates the need for using a template to form a circuit pattern of a printed circuit board. For example, by making the plating catalyst layer in the form of fine wires on a base material and then forming a plating on the layer, a wiring having a narrower wire width can be produced. Such a method, unlike photolithography (photolithography step), has no need to perform photomasking for each different wiring pattern, and requires no expensive photoresist material or exposure device. Thus, this method, in contrast to circuit pattern formation methods including photolithography, can be used simply, requires no expensive material, and is therefore industrially advantageous.

An example of another embodiment of the present invention is a plating catalyst laminate including a base material and a plating catalyst layer having a thickness of 2.0 µm or less, the plating catalyst layer being formed using the above plating catalyst coating agent. The plating catalyst laminate will now be described.

Examples of the base material used in the plating catalyst laminate of the present invention include a metal, an inorganic material (ceramic, glass, etc.), a resin, a rubber, a base material obtained by coating a metal entirely with a resin, and a composite of an inorganic material and a resin.

Examples of the metal used as the base material include aluminum and iron. Examples of the inorganic material include ceramics (e.g., alumina, aluminum nitride, etc.) and glass. Examples of the resin include polycarbonate resin, (meth)aciylic resin, nylon resin, epoxy resin, urethane resin, urethane silicone resin, polyamideimide resin, modified polyamideimide resin, polyimide resin, modified polyimide resin, polyethersulfone resin, fluorine resin, polyester resin, styrene resin, polyvinyl acetal resin, phenolic resin, and PPS (polyphenylene sulfide) resin. Examples of the rubber include silicone rubber (Q), acrylonitrile-butadiene rubber (NBR), butadiene rubber (BR), styrene-butadiene rubber (SBR), butyl rubber (IIR), chloroprene rubber (CR), hydrin rubber (ECO, CO), isoprene rubber (IR), urethane rubber (U), ethylene-propylene-diene rubber (EPDM), and natural rubber (NR). Examples of the composite of an inorganic material and a resin include FRP, a glass-polyimide composite, and a glass-epoxy composite. These may be used alone, or two or more thereof may be used in combination. These may be commercially-available ones.

The base material can be formed, for example, in the shape of a tube or a roll. The base material may consist of one layer or two or more layers. The base material used may be one obtained by laminating a polymer for the base material on a metal sheet such as an aluminum sheet.

The base material used in the present invention may be subjected to surface roughening as necessary for the purpose of further improving the adhesion. The method of the surface roughening is not particularly limited, and a commonly-known method can be used. Examples of the method of the surface roughening include plasma treatment and chemical etching (e.g., desmear treatment etc.). In such surface roughening, for example, a desmear solution described in WO 2013/042582 A1 (a desmear solution containing 0.2 to 0.4 mol/L of a permanganate and an alkali metal hydroxide, in which solution the molar concentration ratio of the permanganate to the alkali metal hydroxide is 1:5 to 1:20) can be used. A commercially-available solution can also be used. Examples of the commercially-available solution include desmear solutions such as APPDES (trade name, registered trademark) MDS-37, MDE-40, ELC-SH, and MDN-62 (manufactured by C.Uyemura & Co., Ltd.).

The thickness of the plating catalyst layer formed using the plating catalyst coating agent of the present invention is 3.0 µm or less, preferably 2.0 µm or less, and more preferably 1.5 µm or less in order that the total thickness of the plating catalyst layer and the plating laminated thereon (the thickness of the plating catalyst layer + the thickness of the plating layer) can be 5.0 µm or less and that the wire width can be narrow (e.g., 5.0 µm or less). In order to maintain the strength, the thickness of the plating catalyst layer is preferably 0.1 µm or more, and more preferably 0.3 µm or more. The thickness of the plating catalyst layer is preferably 0.1 µm or more and 3.0 µm or less, more preferably 0.3 µm or more and 2.0 µm or less, and even more preferably 0.3 µm or more and 1.5 µm or less.

The plating catalyst laminate of the present invention can be produced, for example, by applying the plating catalyst coating agent described above onto the base material.

The method of the application is not particularly limited. For example, commonly-known methods such as spin coating, dip coating, and spray coating can be used. An example of the dip coating is a method in which the base material is immersed in the above plating catalyst coating agent (the plating catalyst coating solution) and then drawn upwardly at a constant speed. Alternatively, the plating catalyst laminate may be obtained by a circuit pattern formation method that does not use a template and in which the plating catalyst coating agent described above is printed onto the base material to make a plating catalyst layer in the form of fine wires and then patterning is performed on the plating catalyst layer. The method of the printing is not particularly limited, and examples thereof include gravure printing, screen printing, flexo printing, offset printing, dry offset printing, pad printing, and inkjet printing. By forming a plating layer by plating onto the patterned plating catalyst layer, a circuit pattern can be formed without the use of a template.

A preferred embodiment of the plating catalyst laminate is one in which, in the plating catalyst layer, the catalyst-supporting carrier (A) supporting the catalytic metal is dispersed throughout the binder (B). In this embodiment, it is preferable that the base material should be a resin or a composite of an inorganic material and a resin, and that the binder (B) should be the aqueous resin emulsion (B1). The base material and the plating catalyst layer are bonded by adhesion between the resin of the base material and the resin emulsion, that is, between polymers. Hence, the adhesion between the base material and the plating catalyst layer can be enhanced. A suitable example of a method of dispersing the catalyst-supporting carrier (A) throughout the binder (B) in the plating catalyst layer is a method in which the plating catalyst coating agent subjected to dispersing using a mulling machine, a kneader, a mixer (e.g., a Henschel mixer etc.) or the like is applied to the base material.

It is preferable to perform drying after the application of the plating catalyst coating agent. The conditions for the drying are not particularly limited. For example, the drying temperature may be about 120 to 180°C.

Through the above step, there is obtained a plating catalyst laminate including a base material and a plating catalyst layer having a thickness of 2.0 µm or less, the plating catalyst layer being formed using the plating catalyst coating agent described above.

Additionally, by subjecting the plating catalyst layer of the plating catalyst laminate to copper plating, a laminate plated with copper (the laminate may be referred to as a "copper-plated laminate" hereinafter) is obtained. The plating catalyst layer has a porous structure and excellent adhesion to the base material. Furthermore, physical bonding between the copper plating layer and the plating catalyst layer is excellent thanks to an anchor effect (fastener effect) caused by the fact that the plating deposited as a result of the copper plating enters the pores of the plating catalyst layer.

In the copper-plated laminate, the plating catalyst layer preferably has, on its surface bonding to the copper plating layer, a region where the catalyst-supporting carrier (A) is exposed. This means that there may be both the catalyst-supporting carrier (A) dispersed within the plating catalyst layer without having any portion exposed on the surface and the catalyst-supporting carrier (A) having a portion exposed on the surface. That is, it is not meant that all of the catalyst-supporting carrier (A) dispersed throughout the plating catalyst layer should be exposed on the surface. During the formation of the plating of the copper plating layer, the catalytic metal in the portion of the catalyst-supporting carrier (A) exposed on the surface of the plating catalyst layer acts as a core on which the copper plating is deposited. Hence, the catalytic metal and the copper plating are bonded by a metallic bond. Additionally, in the catalyst-supporting carrier (A) having a portion exposed on the surface of the plating catalyst layer, the remaining portion that is not exposed on the surface is secured to the binder (B). Thus, the adhesion between the plating catalyst layer and the copper plating layer can be enhanced.

The amount of the catalyst-supporting carrier (A) having a portion exposed on the surface is not particularly limited. It is preferable that the catalyst-supporting carrier (A) having a portion exposed on the surface of the plating catalyst layer should be distributed almost uniformly over the surface. This is because, in this case, the copper plating can be uniformly deposited according to the distribution of the catalytic metal supported on the catalyst-supporting carrier (A) and thus the adhesion between the plating catalyst layer and the copper plating layer is increased. For the catalyst-supporting carrier (A) having a portion exposed on the surface, the proportion of the exposed portion is not particularly limited as long as there is a portion where the catalytic metal supported on the carrier is present outside of the binder (B).

A preferred embodiment of the copper-plated laminate of the present invention is one in which, in the plating catalyst layer, the catalyst-supporting carrier (A) supporting the catalytic metal is dispersed throughout the binder (B). The method of dispersing is as described for the plating catalyst laminate.

A preferred embodiment of the copper-plated laminate is one in which a material (e.g., a resin) used as the base material and a material used as the binder (B) include the same type of substance. In this case, there is an increased affinity between the base material and the plating catalyst layer, which makes it more likely that the adhesion between the base material and the plating catalyst layer is enhanced. A more preferred embodiment is one in which the resin used as the base material and the resin used as the binder (B) are the same type of resin. The expression "same type" is used to include not only the case where the resins are exactly the same but also the case where the resins have the same basic skeleton. That is, for example, different resins classifiable as one type of resin (e.g., epoxy resin) are considered to be the same type of resin. Different rubbers classifiable as one type of rubber (e.g., silicone rubber) are considered to be the same type of resin. Also, the concept of "the same type of substance" is applied to a group of unmodified and modified resins, a group of resins having different molecular weights, and a group of resins having common polymerization units.

The method of copper plating is not particularly limited. Suitable examples thereof include electrolytic copper plating and electroless copper plating. The method of the electrolytic copper plating or the electroless copper plating is not particularly limited, and a conventionally-known method can be used. In these methods, commercially-available products may be used.

The thickness of the copper plating layer is not particularly limited as long as the plating enters the pores of the catalyst layer and also covers the surface of the catalyst layer. For example, the thickness of the copper plating layer may be 0.1 µm or more, and may be 2.0 µm or less.

It is preferable to perform drying subsequent to the electrolytic copper plating or the electroless copper plating. The conditions for the drying are not particularly limited. For example, the drying temperature may be about 120 to 180°C.

The copper-plated laminate of the present invention has a peel strength of preferably 2.0 N or more, more preferably 2.1 N or more, even more preferably 2.3 N or more. The method of measuring the peel strength is as described for the examples given below.

The present invention embraces embodiments in which the above features are combined in various ways within the technical scope of the present invention as long as the embodiments provide the effect of the present invention.

### EXAMPLES

Next, the present invention will be described in more detail by way of examples. However, the present invention is not limited by these examples in any respect, and many modifications can be made by any ordinarily skilled person in the art within the technical concept of the present invention.

### [Example 1]

### Preparation of Catalytic Metal-Containing Source Solution

First, a palladium chloride solution was prepared. Palladium chloride (PdCl₂) (powder) weighing 1.68 g was dissolved in a mixture of 20 mL of a 3.65 wt% (1 mol/L) aqueous hydrochloric acid solution and 500 mL of pure water, and then the resulting solution was diluted with pure water up to 1 L in a measuring cylinder. Thus, the palladium chloride solution was obtained. This solution was used as a 1 g/L palladium source solution (1 g/L-Pd source).

### Preparation of Reductant Solution

Sodium citrate (trisodium citrate) and tannic acid were used as reductants. Specifically, a sodium citrate solution obtained by diluting sodium citrate with pure water to 10 wt%, and a tannic acid solution obtained by diluting tannic acid with pure water to 1.43 wt% were used. As a reaction accelerator, there was used potassium carbonate. Specifically, a potassium carbonate solution obtained by diluting potassium carbonate with pure water to 13.82 wt% (1 mol/L) was used.

### Step [I]

In a 1L round-bottom flask were mixed 200 g of the 1 g/L palladium source solution and 730.61 g of pure water. In this process, a small amount of a 3.65 wt% (1 mol/L) hydrochloric acid solution was added to adjust the pH to 2.3. The resulting mixture was refluxed for 1 hour. To this were added 15 g of the sodium citrate solution, 35 g of the tannic acid solution, and 1.25 g of the potassium carbonate solution which were mixed together. The addition of these solutions was followed by refluxing for 10 minutes, after which the flask was placed in ice water for cooling to room temperature. Ion exchange was then performed with 70 g of an ion exchange resin (AMBERLITE MB-1 (manufactured by ORGANO CORPORATION)) in order to remove impurities. Thus, a colloidal solution of Pd colloidal particles (this solution will be hereinafter referred to as a "Pd colloidal solution") was prepared. The particle diameters of the obtained Pd colloidal particles were measured with a particle size distribution analyzer using dynamic light scattering (DLS) (DLS-6500 manufactured by Otsuka Electronics Co., Ltd.), and the average particle diameter (D50) was determined. The average particle diameter (D50) of the Pd colloidal particles of the present example was 10 nm.

### Step [II]

Next, to the above Pd colloidal solution was added carbon black as a carrier (trade name: VULCAN XC-72, primary average particle diameter: 30 nm, manufactured by Cabot Corporation). The solution was then irradiated with 45 kHz ultrasonic wave for 90 minutes, yielding a dispersion of the Pd fine particles and the carbon black. Subsequently, the dispersion was subjected to dehydration and drying using an evaporator, and then grinding was performed with an agate mortar to obtain Pd fine particle-supporting carbon black (the ratio of the supported Pd fine particles (the ratio of supported catalyst): 1.1 wt%). The Pd fine particle-supporting carbon black (whose weight was used as a reference weight) was put in aqua regia to dissolve Pd at 150°C, the Pd concentration in the solution having been 100-fold diluted with ultrapure water was measured by ICP-MS, and the amount of Pd per reference weight (the ratio of supported catalyst) was calculated.

### Step [III]

Next, to a 100 mL beaker were put 10.0 g of the above Pd fine particle-supporting carbon black, 10.0 g of a polyester resin emulsion as a binder (trade name: Vylonal MD-1500, solids content: 30%, manufactured by TOYOBO CO., LTD.), 6.0 g of ethylene glycol mono-n-butyl ether, and 24.0 g of ultrapure water (50 g in total), and they were kneaded together with a stirrer for 1 hour to obtain a primary mixture. To 15.0 g of this primary mixture were further added 17.0 g of ethylene glycol mono-n-butyl ether and 68.0 g of pure water. Thus, a catalyst coating solution (plating catalyst coating agent) was obtained. The content ratio of the binder solids to the carrier used ((B)/(A)) was 0.30. The term "binder solids" as used herein refers to the total solids other than the carbon black (including the supported material) which contribute to the formation of the plating catalyst layer. In Example 1, solids corresponding to the "binder solids" are only those of the polyester resin emulsion.

Furthermore, an epoxy substrate (trade name: ABF-GX92, a glass epoxy composite manufactured by Ajinomoto Fine-Techno Co., Inc.) cut in the form of a 20-mm-wide, 100-mm-long piece was prepared as a plating base material. The substrate was immersed in the above catalyst coating solution and then drawn upwardly at a constant speed; in this way, the plating catalyst coating agent was applied to the substrate. Next, the substrate was dried at 150°C to obtain a plating catalyst laminate having a plating catalyst layer formed on the substrate. For this laminate, the thickness of the portion coated with the plating catalyst layer and the thickness of the uncoated portion were measured using a micrometer (trade name: MDC-25M, manufactured by Mitutoyo Corporation), and the thickness (µm) of the plating catalyst layer was calculated.

### <Evaluation of Plating Quality>

Subsequently, a copper plating was made by electroless plating using an electroless plating solution (trade name: ATS Addcopper IW, manufactured by OKUNO CHEMICAL INDUSTRIES CO., LTD.). Specifically, the above epoxy substrate on which was formed the plating catalyst layer was immersed in the electroless plating solution for 30 minutes to induce the deposition of a copper plating, which was followed by drying at 150°C for 1 hour.

Evaluations described below were conducted using the electroless copper-plated epoxy substrate (copper-plated laminate) thus obtained. The deposition of the copper plating was evaluated by visual inspection. When the area occupied by the deposited plating was 90% or more of the entire area of the substrate, the plating quality was considered acceptable, whereas when the area occupied by the deposited plating was less than 90%, the plating quality was considered unacceptable. The results are shown in Table 1 below.

### <Evaluation of Adhesion (Peel Strength)>

Before the peel strength test, copper sulfate electroplating was performed on the electroless copper-plated epoxy substrate (copper-plated laminate). The plating solution used was prepared as follows: 750 ml of ultrapure water was mixed with 80 g of copper (II) sulfate pentahydrate which was then dissolved by stirring; 204 g of 98 wt% concentrated sulfuric acid was added little by little to the solution, to which 0.15 mL of 35 wt% hydrochloric acid was further added, followed by stirring; ultrapure water was then added to adjust the total volume to 1000 ml; and to the resulting solution were added 1 mL of THRU-CUP ETN-1-A (manufactured by C.Uyemura & Co., Ltd.) and 10 ml of THRU-CUP ETN-1-B (manufactured by C.Uyemura & Co., Ltd.).

The thus prepared plating solution was poured into a plating bath of an electrolytic plating tester for experimental use (manufactured by YAMAMOTO-MS Co., Ltd.) until the epoxy substrate became submerged in the solution. Then, electrolytic plating was performed at a voltage of 55 V and a current of 0.5 A for 30 minutes, after which rinsing by immersion in ultrapure water was repeated twice and the residual water was removed by air drying with a compressed air gun. Furthermore, the obtained substrate (laminate) was heat-treated at 150°C for 1 hour.

The thus obtained substrate (laminate) was subjected, for evaluation of the adhesion of the plating layer, to a 180° peel test according to JIS K 6854:1994 (Part 2: 180° peel) using a tensile tester (EZ-test, manufactured by Shimadzu Corporation). The sample and condition used for the test were as follows: Sample width = 10 mm, Tensile rate = 10 mm/min. The results are shown in Table 1 below.

### [Example 2]

Preparation of a catalyst coating solution and electroless copper plating were performed in the same manner as in Example 1, except that in the preparation of a primary mixture in the step [III], the amount of the polyester resin emulsion as the binder was 16.7 g, the amount of ethylene glycol mono-n-butyl ether was 4.7 g, and the amount of ultrapure water was 18.6 g. The content ratio of the binder solids to the carrier used ((B)/(A)) was 0.50. For the electroless copper-plated epoxy substrate obtained, measurement of the thickness of the plating catalyst layer and evaluation of the deposition of the copper plating were performed in the same manner as in Example 1. Furthermore, electrolytic plating and evaluation of the adhesion of the plating layer were performed in the same manner as in Example 1. The results are shown in Table 1 below.

### [Comparative Example 1]

Preparation of a catalyst coating solution and electroless copper plating were performed in the same manner as in Example 1, except that in the preparation of a primary mixture in the step [III], the amount of the polyester resin emulsion as the binder was 6.7 g, the amount of ethylene glycol mono-n-butyl ether was 6.7 g, and the amount of ultrapure water was 26.6 g. The content ratio of the binder solids to the carrier used ((B)/(A)) was 0.20. For the electroless copper-plated epoxy substrate obtained, measurement of the thickness of the plating catalyst layer and evaluation of the deposition of the copper plating were performed in the same manner as in Example 1. Furthermore, electrolytic plating and evaluation of the adhesion of the plating layer were performed in the same manner as in Example 1. The results are shown in Table 1 below.

### [Comparative Example 2]

Preparation of a catalyst coating solution and electroless copper plating were performed in the same manner as in Example 1, except that in the preparation of a primary mixture in the step [III], the amount of the polyester resin emulsion as the binder was 25.0 g, the amount of ethylene glycol mono-n-butyl ether was 3.0 g, and the amount of ultrapure water was 12.0 g. The content ratio of the binder solids to the carrier used ((B)/(A)) was 0.75. For the electroless copper-plated epoxy substrate obtained, measurement of the thickness of the plating catalyst layer and evaluation of the deposition of the copper plating were performed in the same manner as in Example 1. The results are shown in Table 1 below.

### [Comparative Example 3]

Preparation of a catalyst coating solution and electroless copper plating were performed in the same manner as in Example 1, except that in the preparation of a primary mixture in the step [III], the amount of the polyester resin emulsion as the binder was 33.3 g, the amount of ethylene glycol mono-n-butyl ether was 1.3 g, and the amount of ultrapure water was 5.4 g. The content ratio of the binder solids to the carrier used ((B)/(A)) was 1.0. For the electroless copper-plated epoxy substrate obtained, measurement of the thickness of the plating catalyst layer and evaluation of the deposition of the copper plating were performed in the same manner as in Example 1. The results are shown in Table 1 below.

### [Example 3]

Preparation of a catalyst coating solution and electroless copper plating were performed in the same manner as in Example 1, except that in the step [III], a primary mixture was prepared using 10.0 g of the Pd fine particle-supporting carbon black of Example 1, 4.4 g of a bisphenol A-modified epoxy resin emulsion as a binder (trade name: Daitosizer DT-256, solids content: 50%, manufactured by DAITO SANGYO CO., LTD.), and 35.6 g of ultrapure water (50 g in total), and that 0.46 g of a modified aliphatic polyamine (trade name: Daitocurar X-7024, solids content: 50%, manufactured by DAITO SANGYO CO., LTD.) serving as a curing agent for the modified epoxy resin emulsion and 84.54 g of ultrapure water were added to 15 g of the prepared primary mixture. The content ratio of the binder solids to the carrier used ((B)/(A)) was 0.30. In this example, solids corresponding to the binder solids were solids of the bisphenol A-modified epoxy resin emulsion and solids of the modified aliphatic polyamine. For the electroless copper-plated epoxy substrate obtained, measurement of the thickness of the plating catalyst layer and evaluation of the deposition of the copper plating were performed in the same manner as in Example 1. Furthermore, electrolytic plating and evaluation of the adhesion of the plating layer were performed in the same manner as in Example 1. The results are shown in Table 1 below.

### [Example 4]

Preparation of a catalyst coating solution and electroless copper plating were performed in the same manner as in Example 3, except that in the preparation of a primary mixture in the step [III], the amount of the bisphenol A-modified epoxy resin emulsion as the binder was 7.4 g and the amount of ultrapure water was 32.6 g, and that the amounts of the modified aliphatic polyamine and ultrapure water added to 15.0 g of the prepared primary mixture were 0.78 g and 84.22 g, respectively. The content ratio of the binder solids to the carrier used ((B)/(A)) was 0.50. For the electroless copper-plated epoxy substrate obtained, measurement of the thickness of the plating catalyst layer and evaluation of the deposition of the copper plating were performed in the same manner as in Example 1. Furthermore, electrolytic plating and evaluation of the adhesion of the plating layer were performed in the same manner as in Example 1. The results are shown in Table 1 below.

### [Comparative Example 4]

Preparation of a catalyst coating solution and electroless copper plating were performed in the same manner as in Example 3, except that in the preparation of a primary mixture in the step [III], the amount of the bisphenol A-modified epoxy resin emulsion as the binder was 3.0 g and the amount of ultrapure water was 37.0 g, and that the amounts of the modified aliphatic polyamine and ultrapure water added to 15.0 g of the prepared primary mixture were 0.32 g and 84.68 g, respectively. The content ratio of the binder solids to the carrier used ((B)/(A)) was 0.20. For the electroless copper-plated epoxy substrate obtained, measurement of the thickness of the plating catalyst layer and evaluation of the deposition of the copper plating were performed in the same manner as in Example 1. Furthermore, electrolytic plating and evaluation of the adhesion of the plating layer were performed in the same manner as in Example 1. The results are shown in Table 1 below.

### [Comparative Example 5]

Preparation of a catalyst coating solution and electroless copper plating were performed in the same manner as in Example 3, except that in the preparation of a primary mixture in the step [III], the amount of the bisphenol A-modified epoxy resin emulsion as the binder was 11.1 g and the amount of ultrapure water was 28.9 g, and that the amounts of the modified aliphatic polyamine and ultrapure water added to 15.0 g of the prepared primary mixture were 1.17 g and 83.83 g, respectively. The content ratio of the binder solids to the carrier used ((B)/(A)) was 0.75. For the electroless copper-plated epoxy substrate obtained, measurement of the thickness of the plating catalyst layer and evaluation of the deposition of the copper plating were performed in the same manner as in Example 1. The results are shown in Table 1 below.

### [Comparative Example 6]

Preparation of a catalyst coating solution and electroless copper plating were performed in the same manner as in Example 1, except that carbon black having a relatively large particle diameter (trade name: Thermax N990, average particle diameter: 280 nm, manufactured by Cancarb) was used as the carrier carbon, and that in the preparation of a primary mixture, the amount of the polyester resin emulsion as the binder was 16.7 g, the amount of ethylene glycol mono-n-butyl ether was 4.7 g, and the amount of ultrapure water was 18.6 g. The content ratio of the binder solids to the carrier used ((B)/(A)) was 0.50. For the electroless copper-plated epoxy substrate obtained, measurement of the thickness of the plating catalyst layer and evaluation of the deposition of the copper plating were performed in the same manner as in Example 1. Furthermore, electrolytic plating and evaluation of the adhesion of the plating layer were performed in the same manner as in Example 1. The results are shown in Table 1 below.

### [Comparative Example 7]

Preparation of a catalyst coating solution and electroless copper plating were performed in the same manner as in Comparative Example 6, except that in the preparation of a primary mixture in the step [III], the amount of the polyester resin emulsion as the binder was 25.0 g, the amount of ethylene glycol mono-n-butyl ether was 3.0 g, and the amount of ultrapure water was 12.0 g. The content ratio of the binder solids to the carrier used ((B)/(A)) was 0.75. For the electroless copper-plated epoxy substrate obtained, measurement of the thickness of the plating catalyst layer and evaluation of the deposition of the copper plating were performed in the same manner as in Example 1. Furthermore, electrolytic plating and evaluation of the adhesion of the plating layer were performed in the same manner as in Example 1. The results are shown in Table 1 below.

### [Comparative Example 8]

Preparation of a catalyst coating solution and electroless copper plating were performed in the same manner as in Comparative Example 6, except that in the preparation of a primary mixture in the step [III], the amount of the polyester resin emulsion as the binder was 33.3 g, the amount of ethylene glycol mono-n-butyl ether was 1.3 g, and the amount of ultrapure water was 5.4 g. The content ratio of the binder solids to the carrier used ((B)/(A)) was 1.0. For the electroless copper-plated epoxy substrate obtained, measurement of the thickness of the plating catalyst layer and evaluation of the deposition of the copper plating were performed in the same manner as in Example 1. Furthermore, electrolytic plating and evaluation of the adhesion of the plating layer were performed in the same manner as in Example 1. The results are shown in Table 1 below.

Next, surface roughening of the substrate, thinning and rarefaction of the catalyst layer were performed in order to further enhance the adhesion strength of the plating. That is, it was aimed to enhance the adhesion by a so-called anchor effect caused by the fact that the deposited plating layer penetrates through the porous catalyst layer and enters the recesses of the roughened substrate surface.

### [Example 5]

First, surface roughening of the substrate was performed. For the roughening, a commercially-available desmear solution was used. There were mixed 50 ml of "APPDES MDS-37" (swelling solution) manufactured by C.Uyemura & Co., Ltd. and 50 ml of pure water. The mixture was heated to 60°C. The substrate was immersed in the mixture for 5 minutes, then subjected twice to rinsing by immersion in pure water, and dried naturally. Next, 7 ml of "MDE-40" (etching solution) manufactured by C.Uyemura & Co., Ltd., 37 ml of "ELC-SH" (etching solution) manufactured by C.Uyemura & Co., Ltd., and 56 ml of pure water were mixed, and the mixture was heated to 70°C. The substrate treated as above was immersed in the mixture for 15 minutes, then subjected twice to rinsing by immersion in pure water, and dried naturally. Furthermore, 10 ml of "MDN-62" (neutralizing solution) manufactured by C.Uyemura & Co., Ltd. and 90 ml of pure water were mixed, and the mixture was heated to 35°C. The treated substrate was immersed in the mixture for 5 minutes, then subjected twice to rinsing by immersion in pure water, and dried naturally. Thus, a surface-roughened substrate was obtained.

Next, to a 100 ml beaker were put 10.0 g of the Pd fine particle-supporting carbon black of Example 1, 16.7 g of a polyester emulsion resin as a binder (trade name: Vylonal MD-1500, solids content: 30%, manufactured by TOYOBO CO., LTD.), 4.7 g of ethylene glycol mono-n-butyl ether, and 18.6 g of ultrapure water (50 g in total), and they were kneaded together with a stirrer for 1 hour to obtain a primary mixture. Furthermore, 19.0 g of ethylene glycol mono-n-butyl ether and 76.0 g of ultrapure water were added to 5.0 g of the primary mixture to obtain a catalyst coating solution. The content ratio of the binder solids to the carrier used ((B)/(A)) was 0.50.

Subsequently, the surface-roughened substrate was coated with the catalyst coating solution in the same manner as in Example 1. Electroless plating and electrolytic plating were further performed to obtain a plating catalyst laminate having a plating catalyst layer formed on the substrate. The peel strength of the plating layer, as measured in the same manner as in Example 1, was 4.0 N. Additionally, measurement of the thickness of the plating catalyst layer and evaluation of the deposition of the copper plating were performed in the same manner as in Example 1. The results are shown in Table 1 below. Furthermore, a cross-section observation with a scanning electron microscope was carried out. Entry of the plating into the recesses formed by the roughening of the substrate was confirmed.

### [Example 6]

Surface roughening of the substrate was performed in the same manner as in Example 5. Next, 18.0 g of ethylene glycol mono-n-butyl ether and 72.0 g of ultrapure water were added to 10 g of a primary mixture prepared using the Pd fine particle-supporting carbon black in the same manner as in Example 5. The content ratio of the binder solids to the carrier used ((B)/(A)) was 0.50.

Subsequently, the surface-roughened substrate was coated with the catalyst coating solution in the same manner as in Example 1. Electroless plating and electrolytic plating were further performed to obtain a plating catalyst laminate having a plating catalyst layer formed on the substrate. The peel strength of the plating layer, as measured in the same manner as in Example 1, was 3.4 N. Additionally, measurement of the thickness of the plating catalyst layer and evaluation of the deposition of the copper plating were performed in the same manner as in Example 1. The results are shown in Table 1 below. Furthermore, by a cross-section observation with a scanning electron microscope, entry of the plating into the recesses formed by the roughening of the substrate was confirmed.

### [Example 7]

Surface roughening of the substrate was performed in the same manner as in Example 5. Next, 17.0 g of ethylene glycol mono-n-butyl ether and 68.0 g of ultrapure water were added to 15 g of a primary mixture prepared using the Pd fine particle-supporting carbon black in the same manner as in Example 5. The content ratio of the binder solids to the carrier used ((B)/(A)) was 0.50.

Subsequently, the surface-roughened substrate was coated with the catalyst coating solution in the same manner as in Example 1. Electroless plating and electrolytic plating were further performed to obtain a plating catalyst laminate having a plating catalyst layer formed on the substrate. The peel strength of the plating layer, as measured in the same manner as in Example 1, was 2.2 N. Additionally, measurement of the thickness of the plating catalyst layer and evaluation of the deposition of the copper plating were performed in the same manner as in Example 1. The results are shown in Table 1 below. Although a cross-section observation with a scanning electron microscope was performed, entry of the plating into the recesses formed by the roughening of the substrate was not confirmed.

**[Table 1]**

| | Average particle diameter (D50) of carrier (A) (nm) | Content ratio (B)/(A) | Thickness of plating catalyst layer µm) | Deposition of plating | Peel strength (N) | Roughening of substrate | Entry of plating into recesses formed by roughening | Comprehensive evaluation |
|---|---|---|---|---|---|---|---|---|
| Example 1 | 30 | 0.30 | 1.3 | Acceptable | 2.0 | Not Performed | - | Good |
| Example 2 | 30 | 0.50 | 1.5 | Acceptable | 2.3 | Not Performed | - | Good |
| Comp. Example 1 | 30 | 0.20 | 1.2 | Acceptable | 0.8 | Not Performed | - | Poor |
| Comp. Example 2 | 30 | 0.75 | 1.8 | Unacceptable | N/A | Not Performed | - | Poor |
| Comp. Example 3 | 30 | 1.0 | 2.0 | Unacceptable | N/A | Not Performed | - | Poor |
| Example 3 | 30 | 0.30 | 1.2 | Acceptable | 2.1 | Not Performed | - | Good |
| Example 4 | 30 | 0.50 | 1.4 | Acceptable | 2.4 | Not Performed | - | Good |
| Comp. Example 4 | 30 | 0.20 | 1.1 | Acceptable | 0.9 | Not Performed | - | Poor |
| Comp. Example 5 | 30 | 0.75 | 1.7 | Unacceptable | N/A | Not Performed | - | Poor |
| Comp. Example 6 | 280 | 0.50 | 3.5 | Acceptable | 1.3 | Not Performed | - | Poor |
| Comp. Example 7 | 280 | 0.75 | 3.4 | Acceptable | 1.4 | Not Performed | - | Poor |
| Comp. Example 8 | 280 | 1.0 | 3.6 | Acceptable | 1.4 | Not Performed | - | Poor |
| Example 5 | 40 | 0.50 | 1.0 | Acceptable | 4.0 | Performed | Confirmed | Excellent |
| Example 6 | 40 | 0.50 | 1.8 | Acceptable | 3.4 | Performed | Confirmed | Excellent |
| Example 7 | 40 | 0.50 | 2.7 | Acceptable | 2.2 | Performed | Not confirmed | Good |

| | | | | | | | | |
|---|---|---|---|---|---|---|---|---|
| (N/A means that measurement was not possible.) | | | | | | | | |

In Table 1 above, the criteria for the comprehensive evaluation are as follows.

Excellent: The thickness of the plating catalyst layer was not more than 2.0 µm, the plating quality was evaluated as acceptable, and the peel strength was not less than 3.0 N.

Good: The thickness of the plating catalyst layer was not more than 3.0 µm, the plating quality was evaluated as acceptable, and the peel strength was not less than 2.0 N and less than 3.0 N.

Poor: The plating quality was evaluated as unacceptable or the peel strength was less than 2.0 N.

Table 1 shows that in Examples 1 to 4 using plating catalyst coating agents according to the present invention, good plating quality and a peel strength of 2.0 N or more were observed, and thin plating catalyst layers having a thickness of 1.5 µm or less were successfully formed. By contrast, Comparative Examples 1 and 4 were inferior in peel strength, and Comparative Examples 2, 3, and 5 were poor in plating quality and were not able to be subjected to the measurement of the peel strength. In Comparative Examples 6 to 8, the thickness of the plating catalyst layer was 3.4 µm or more, and the peel strength obtained was only 1.4 N or less. As demonstrated in Examples 5 to 7, a peel strength of 2.2 N or more was successfully achieved by virtue of surface roughening of the substrate. Particularly, as demonstrated in Examples 5 and 6, when the substrate was surface-roughened and the thickness of the plating catalyst layer was 1.8 µm or less, good plating quality was obtained, in addition to which plating catalyst laminates having a peel strength of 3.4 N or more were obtained thanks to the increase in peel strength caused by an anchor effect provided by entry of the plating into the recesses of the substrate.

The plating catalyst coating agent of the present invention offers good plating quality, is excellent in adhesion, and enables thinning of a plating catalyst layer. The fact that the plating catalyst layer can be thinned makes it possible for the total thickness of the plating catalyst layer and the plating laminated thereon (the thickness of the plating catalyst layer + the thickness of the plating layer) to be 5.0 µm or less and for the wire width to be narrow (e.g., 5.0 µm or less). Additionally, the circuit pattern formation method using the plating catalyst coating agent of the present invention, in contrast to circuit pattern formation methods using photolithography, has no need to perform photomasking for each different wiring pattern, requires no expensive photoresist material or exposure device, and uses no template. Therefore, the present invention is industrially advantageous as a technique for forming circuits of printed circuit boards.

## Claims

1. A plating catalyst coating agent comprising a carrier (A) supporting catalytic metal fine particles and a binder (B), wherein
the binder (B) comprises an aqueous resin emulsion (B1),
the carrier (A) has an average particle diameter (D50) of 20 to 90 nm,
the catalytic metal fine particles supported on the carrier (A) comprise palladium, and
a content ratio of the binder (B) to the carrier (A) ((B)/(A)) is 0.25 to 0.60.

2. The plating catalyst coating agent according to claim 1, wherein the catalytic metal fine particles are palladium fine particles.

3. The plating catalyst coating agent according to claim 1 or 2, wherein the catalytic metal fine particles have an average particle diameter (D50) of 5 nm or more and 40 nm or less.

4. The plating catalyst coating agent according to any one of claims 1 to 3, wherein the binder (B) further comprises a curing agent (B2) for the aqueous resin emulsion (B1).

5. The plating catalyst coating agent according to any one of claims 1 to 4, wherein the plating catalyst coating agent is used for electroless copper plating.

6. A plating catalyst laminate comprising a base material and a plating catalyst layer having a thickness of 2.0 µm or less, wherein the plating catalyst layer is formed using the plating catalyst coating agent according to any one of claims 1 to 5.
